# EUROPEAN PATENT APPLICATION

(11) **EP 4 807 747 A1**
(43) Date of publication of application: **16.09.2026**
(21) Application number: 26159756.1
(22) Date of filing: 20.02.2026
(51) Int. Cl.: G11C 29/42, G06F 11/10, G11C 29/52

(54) **NON-VOLATILE MEMORY, AND RELATED SYSTEM AND METHOD FOR PROTECTING INTERNAL FLIP-FLOPS OF A NON-VOLATILE MEMORY**

(30) Priority: 10.03.2025 US 202519075457
(71) Applicant: STMicroelectronics International N.V., 1228 Plan-les-Ouates, Geneva (CH)
(72) Inventor: COLOMBO, Roberto, 81829 München (DE); DISEGNI, Fabio Enrico Carlo, 26016 Spino d'Adda (IT)
(74) Representative: Buzzi, Notaro & Antonielli d'Oulx S.p.A.

(57) **Abstract**

A method includes reading data (110) from a non-volatile memory (NVM) array (108) and performing an error detection process on read data (110). In response to detecting an error in the read data, the method further includes performing an integrity check process on a flip-flop (FF) system (130). Performing the integrity check process includes determining whether any of FF values (134) of the FF system (130) are corrupted. In response to detecting FF system (130) corruption, the method further includes determining that the error is an FF system error, sending a reset request (128) to a reset generator (140), receiving reset instructions (142) from the reset generator (140), and resetting the FF system (130).

## Description

### Technical Field

The present disclosure relates generally to a system and method for protecting a non-volatile memory, and, in particular embodiments, to a system and method for protecting internal flip-flops of a non-volatile memory.

### Background

Non-volatile memory systems, e.g., in automotive microcontrollers play an important role in storing and maintaining data integrity, e.g., for vehicle operations. These memory systems retain their contents even when power is removed, making them essential for storing program code, calibration data, and configuration parameters. For example, the reliability and proper functioning of non-volatile memory may directly impact vehicle safety and operation, particularly in modern autonomous driving applications where complex control algorithms rely on stored data.

When data is read from a non-volatile memory, it is validated to ensure its integrity has not been compromised by events such as radiation effects, voltage fluctuations, or other environmental factors. Error detection and correction mechanisms are typically employed to identify and address potential data corruption, with specific timing requirements for fault detection and system response to maintain safe vehicle operation.

### Summary

Specifically, one or more embodiments relate to a non-volatile memory having the distinctive elements set forth specifically in the ensuing claims. Embodiments moreover concern a related system and method.

The scope of protection is defined in the appended claims, which form an integral part of the technical teaching of the description provided herein.

In accordance with another embodiment, a non-volatile memory includes: a non-volatile memory (NVM) array configured to store an NVM data and first flip-flop (FF) values; an FF system configured to store second FF values; and a processor operably coupled to the NVM array and the FF system, where the processor is configured to: read a portion of the NVM data from the NVM; perform an error detection process on read portion of the NVM data; and in response to detecting an error in the read portion of the NVM data: perform an integrity check process on the FF system, where performing the integrity check process includes determining whether any of second FF values of the FF system are corrupted; and in response to detecting FF system corruption: determine that the error is an FF system error; send a reset request to a reset generator; receive reset instructions from the reset generator; and reset the FF system. In an embodiment, the processor is further configured to, in response to detecting no FF system corruption, determine that the error is an NVM error and send the NVM error to a fault collector. In an embodiment, the error is a single-bit flip error, a double-bit flip error, or a triple-bit flip error. In an embodiment, resetting the FF system includes: reading one or more first FF values from the NVM array that correspond to one or more corrupted second FF values of the FF system; and overwriting the one or more corrupted second FF values with corresponding one or more first FF values. In an embodiment, the second FF values include mapping tables that redirect accesses from defective wordlines or bitlines to spare wordlines or bitlines, and defect location addresses detected during post-manufacturing tests. In an embodiment, the NVM array is further configured to store an error correction code (ECC) algorithm; and performing the error detection process on the read portion of the NVM data includes executing the ECC algorithm. In an embodiment, the NVM array is further configured to store an integrity check algorithm and performing the integrity check process on the FF system includes executing the integrity check algorithm.

In accordance with an embodiment, a system includes: a fault collector; a reset generator; and a non-volatile memory (NVM) operably coupled to the fault collector and the reset generator, the NVM including an NVM array and a flip-flop (FF) system, where the NVM is configured to: read data from the NVM array; perform an error detection process on read data; and in response to detecting an error in the read data: perform an integrity check process on the FF system, where performing the integrity check process includes determining whether any of FF values of the FF system are corrupted; and in response to detecting FF system corruption: determine that the error is an FF system error; send a reset request to the reset generator; receive reset instructions from the reset generator; and reset the FF system. In an embodiment, the NVM is further configured to, in response to detecting no FF system corruption, determine that the error is an NVM error and send the NVM error to the fault collector. In an embodiment, the fault collector is configured to generate system instructions based on the NVM error. In an embodiment, the error is a single-bit flip error, a double-bit flip error, or a triple-bit flip error. In an embodiment, resetting the FF system includes: reading FF values from the NVM array that correspond to corrupted FF values of the FF system; and overwriting the corrupted FF values with corresponding read FF values. In an embodiment, the FF values include mapping tables that redirect accesses from defective wordlines or bitlines to spare wordlines or bitlines, and defect location addresses detected during post-manufacturing tests. In an embodiment, the reset generator is configured to generate the reset instructions based on the reset request.

In accordance with yet another embodiment, a method includes: reading data from a non-volatile memory (NVM) array; performing an error detection process on read data; and in response to detecting an error in the read data: performing an integrity check process on a flip-flop (FF) system, where performing the integrity check process includes determining whether any of FF values of the FF system are corrupted; and in response to detecting FF system corruption: determining that the error is an FF system error; sending a reset request to a reset generator; receiving reset instructions from the reset generator; and resetting the FF system. In an embodiment, the method further includes, in response to detecting no FF system corruption, determining that the error is an NVM error and sending the NVM error to a fault collector. In an embodiment, the method further includes generating system instructions based on the NVM error. In an embodiment, the error is a single-bit flip error, a double-bit flip error, or a triple-bit flip error. In an embodiment, resetting the FF system includes: reading FF values from the NVM array that correspond to corrupted FF values of the FF system; and overwriting the corrupted FF values with corresponding read FF values. In an embodiment, the FF values include mapping tables that redirect accesses from defective wordlines or bitlines to spare wordlines or bitlines, and defect location addresses detected during post-manufacturing tests.

### Brief Description of the Drawings

For a more complete understanding of the present disclosure, and the advantages thereof, reference is now made to the following descriptions taken in conjunction with the accompanying drawings, in which:
- Figure 1A illustrates a schematic view of a memory system, in accordance with some embodiments;
- Figure 1B illustrates a schematic view of a memory system, in accordance with some embodiments;
- Figure 2 is a sequence diagram of a method for protecting internal flip-flops of a non-volatile memory, according to some embodiments;
- Figure 3 illustrates a table showing a framework for error handling and system responses across different scenarios, in accordance with some embodiments; and
- Figures 4A and 4B illustrate a flowchart of a method for protecting internal flip-flops of a non-volatile memory, in accordance with some embodiments.

### Detailed Description of Illustrative Embodiments

The present disclosure describes a system and method for protecting internal flip-flops of a non-volatile memory. Various embodiments of the present disclosure are described in the contexts of automotive applications. However, various embodiments may be also employed in other applications and are not limited to automotive applications.

The present disclosure provides a system and method for protecting flip-flops internal to a non-volatile memory through an integrated integrity checker function. The system includes a non-volatile memory array, a processor, and a flip-flop system, where the integrity checker monitors data integrity and determines whether detected errors originate from actual memory corruption or from flip-flop corruption. Upon detecting an error during memory read operations, the system automatically activates the integrity checker to validate the state of the flip-flops.

In various embodiments, the system employs a fault collector to process error information and a reset generator to manage system resets when needed. When the integrity checker determines that flip-flop corruption has occurred, it triggers a reset to restore proper operation of the flip-flop system. Alternatively, if the integrity checker confirms the flip-flop integrity, it identifies the fault as a memory error and initiates appropriate error handling procedures through the fault collector. The system operates within defined time intervals to ensure fault detection and response meet desired requirements such as automotive safety requirements, for example.

Various embodiments of present disclosure provide various benefits. Various embodiments enable a safety mechanism that effectively identifies flip-flop corruptions with reduced silicon area compared to traditional triple-voting approaches. In various embodiments, the area reduction is achieved by implementing the integrity checker through firmware rather than dedicated hardware, eliminating the need for physical duplication of flip-flops while maintaining improved error detection capabilities. The firmware-based approach also provides flexibility in tailoring the detection strategy and updating protection mechanisms even after device production.

Various embodiments create no performance impact during normal operation since the integrity checker is activated only when faults are detected. In various embodiments, the system allows for dynamic identification of safety-critical flip-flops without requiring a fixed assignment during design development, avoiding both overly conservative area allocation and potential safety gaps. Various embodiments enable optimal resource utilization while maintaining comprehensive protection of critical system elements.

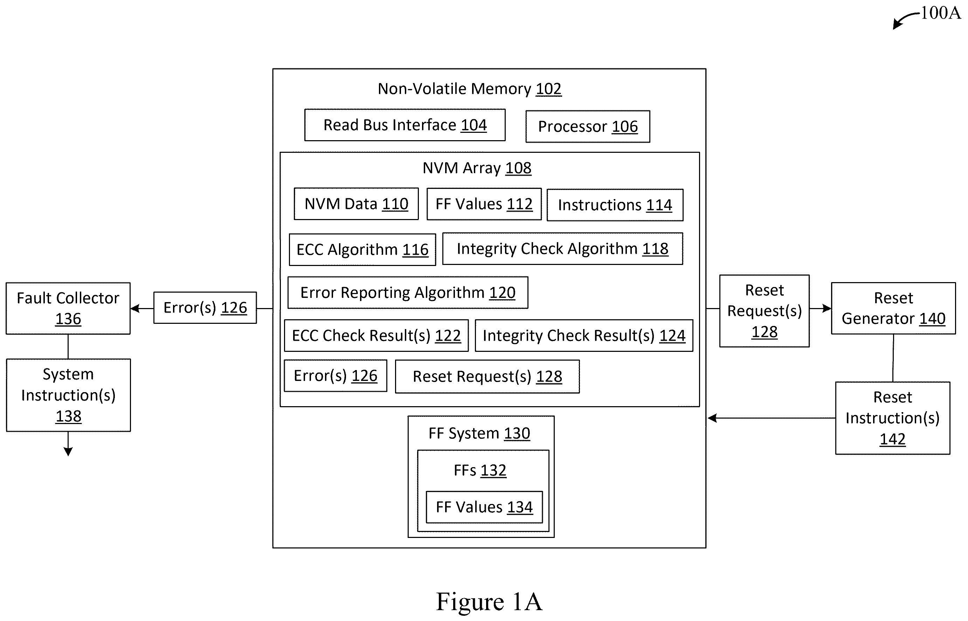

Figure 1A illustrates a schematic view of a memory system 100A, in accordance with some embodiments. Memory system 100A comprises a non-volatile memory (NVM) 102 operably connected to a fault collector 136 and a reset generator 140. NVM 102 comprises several components that work together to manage data integrity and error handling. In the illustrated embodiment, NVM 102 comprises a read bus interface 104, a processor 106, an NVM array 108, and a flip-flop (FF) system 130 operably connected to each other.

In the embodiment considered, read bus interface 104 provides a communication pathway for transferring data between NVM 102 and external components. In various embodiments, read bus interface 104 enables read operations to access data (e.g., NVM data 110) stored in NVM 102.

In the embodiment considered, processor 106 serves as a control unit within NVM 102. Processor 106 may comprise one or more processors (e.g., microprocessor, microcontroller, central processing unit, etc.), programmable logic devices (e.g., complex programmable logic device (CPLD)), field programmable gate array (FPGA), etc.), and/or other programmable integrated circuits can be programmed with software or other programming instructions (e.g., instructions 114, error correction code (ECC) algorithm 116, integrity check algorithm 118, and error reporting algorithm 120) stored in NVM array 108 to implement the functionality of the memory system 100A.

In the embodiment considered, NVM array 108 provides non-volatile storage for data that are retained when power is removed. In various embodiments, NVM array 108 stores both NVM data 110 and FF values 112. NVM data 110 represents a primary storage content while FF values 112 comprise configuration settings that control operations of the NVM 102. In an embodiment, FF values 112 comprise voltage reference levels for read operations, program voltage levels, timing parameters for memory access, operating mode selections, or the like. The configuration settings may also comprise calibration values that optimize performance across temperature variations and compensate for manufacturing process variations. In an embodiment, FF values 112 further comprise memory defectiveness information used for managing defective memory locations (e.g., defective wordlines or bitlines). Defectiveness information may include mapping tables that redirect accesses from defective wordlines or bitlines to spare wordlines or bitlines and defect location addresses detected during post-manufacturing tests.

In some embodiments, FF system 130 comprises FFs 132 that store FF values 134. During initialization or reset operations, FF values 112 are loaded from the NVM array 108 into FF system 130 as FF values 134. In some embodiments, FFs 132 may comprise S-R FFs, J-K FFs, D FFs, T FFs, combinations thereof, or the like.

In some embodiments, NVM array 108 further stores instructions 114, error correction code (ECC) algorithm 116, integrity check algorithm 118, and error reporting algorithm 120. Instructions 114 comprise instructions that implement internal functionality of the NVM 102. In an embodiment, processor 106, when executing instructions 114, implements internal NVM logic for NVM 102. In an embodiment, ECC algorithm 116 performs error detection and correction on data (e.g., a portion of NVM data 110) that is read from the NVM array 108, integrity check algorithm 118 checks integrity of FF values 134 stored in FF system 130, and error reporting algorithm 120 manages how errors are communicated to the fault collector 136.

In an embodiment, integrity check algorithm 118 implements a duplication strategy where NVM 102 maintains a duplicate copy of flip-flop values (e.g., FF values 134) in a local random access memory (RAM) accessible by processor 106 of NVM 102. Integrity check algorithm 118 compares each flip-flop value with its reference copy stored in the local RAM. This implementation provides rapid validation capability and can detect any desired number of flipped bits.

In another embodiment, integrity check algorithm 118 implements a parity strategy where reference parity values are calculated and maintained over flip-flops (FFs) 132. The FFs 132 may be handled as a single group or divided into multiple sets for parity calculation. During execution, integrity check algorithm 118 generates new parity values and compares them against stored reference values. This approach allows fast execution with simple implementation and allows for detecting odd numbers of flipped bits.

In yet another embodiment, integrity check algorithm 118 implements a checksum strategy where reference checksum values are calculated and maintained over FFs 132. FFs 132 may be handled as a single group or divided into multiple sets for checksum calculation. During validation, integrity check algorithm 118 generates new checksums from current flip-flop values and compares them against stored reference checksums. This approach allows for reducing area overhead while maintaining the ability to detect multiple bit flips.

In yet another embodiment, integrity check algorithm 118 implements an ECC strategy where reference ECC codes are calculated and maintained over FFs 132. FFs 132 may be handled as a single group or divided into multiple sets for ECC code calculation. During execution, integrity check algorithm 118 generates new ECC codes and compares them against stored reference ECC codes. This implementation allows for both multiple-bit flip error detection and single-bit flip error correction capabilities.

In various embodiments, the choice between these implementations of integrity check algorithm 118 depends on system requirements regarding area constraints, execution speed requirements, and error detection capabilities. The checksum implementation often provides an effective balance between area utilization and error detection capabilities, though specific system needs may favor other implementations.

In some embodiments, NVM 102 generates several types of results and signals. ECC check results 122 indicate outcomes of error detection and correction operations performed on NVM data 110. Integrity check results 124 reflect states of validation of FF values 134 stored in FF system 130. Errors 126 represent detected faults or anomalies in NVM data 110. Reset requests 128 are generated when resets of FF system 130 are needed.

Fault collector 136 receives errors 126 from NVM 102 and generates system instructions 138 based on errors 126. System instructions 138 comprise various responses of memory system 100A in response to detected errors and anomalies. Reset generator 140 generates reset instructions 142 based on reset requests 128 received from NVM 102 and provides reset instructions 142 to NVM 102. In some embodiments, in response to receiving reset instructions 142, NVM 102 resets the FF system 130 by overwriting FF values 134 with FF values 112 stored in NVM array 108.

In some embodiments, each of fault collector 136 and reset generator 140 may be implemented using a computing system comprising a processor operable coupled to a memory. Processor may comprise one or more processors (e.g., microprocessor, microcontroller, central processing unit, etc.), programmable logic devices (e.g., complex programmable logic device (CPLD)), field programmable gate array (FPGA), etc.), and/or other programmable integrated circuits can be programmed with software or other programming instructions to implement functionalities of fault collector 136 or reset generator 140.

In some embodiments, the software or other programming instructions can be stored in memory. Memory may comprise one or more non-transitory computer-readable mediums (e.g., memory storage devices, FLASH memory, DRAM memory, reprogrammable storage devices, hard drives, floppy disks, DVDs, CD-ROMs, etc.), and the software or other programming instructions, when executed by the processor, cause the processor to perform the processes, functions, and/or capabilities of fault collector 136 or reset generator 140.

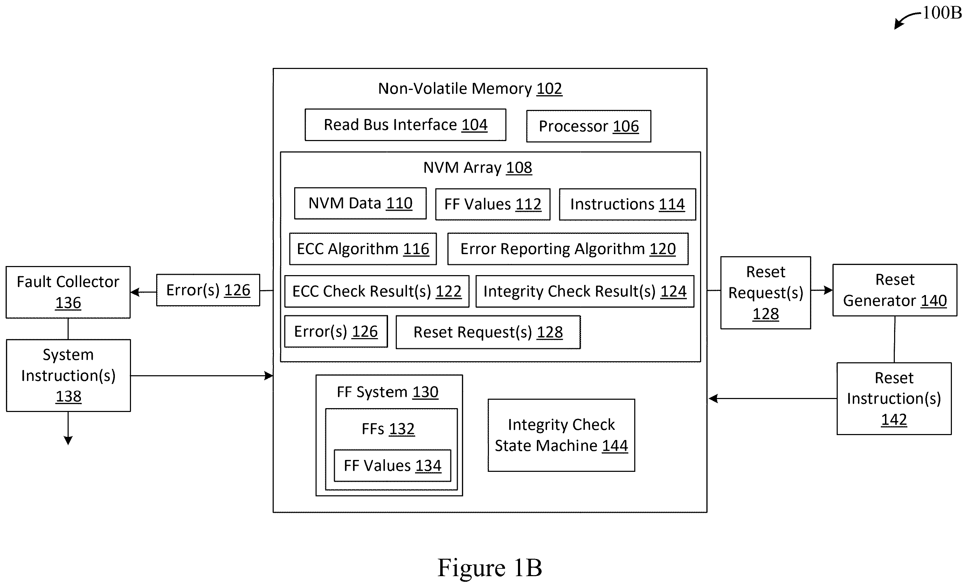

Figure 1B illustrates a schematic view of a memory system 100B, in accordance with some embodiments. Memory system 100B is similar to memory system 100A (see Figure 1A), with similar features being labeled by similar numerical references, and descriptions of the similar features are not repeated herein. In the illustrated embodiment, NVM 102 comprises integrity check state machine 144 instead of integrity check algorithm 118 (see Figure 1A). Integrity check state machine 144 provides dedicated hardware control for managing the integrity check operations. Memory system 100B allows for hardware-based management of integrity checking rather than a software-based approach employed by memory system 100A.

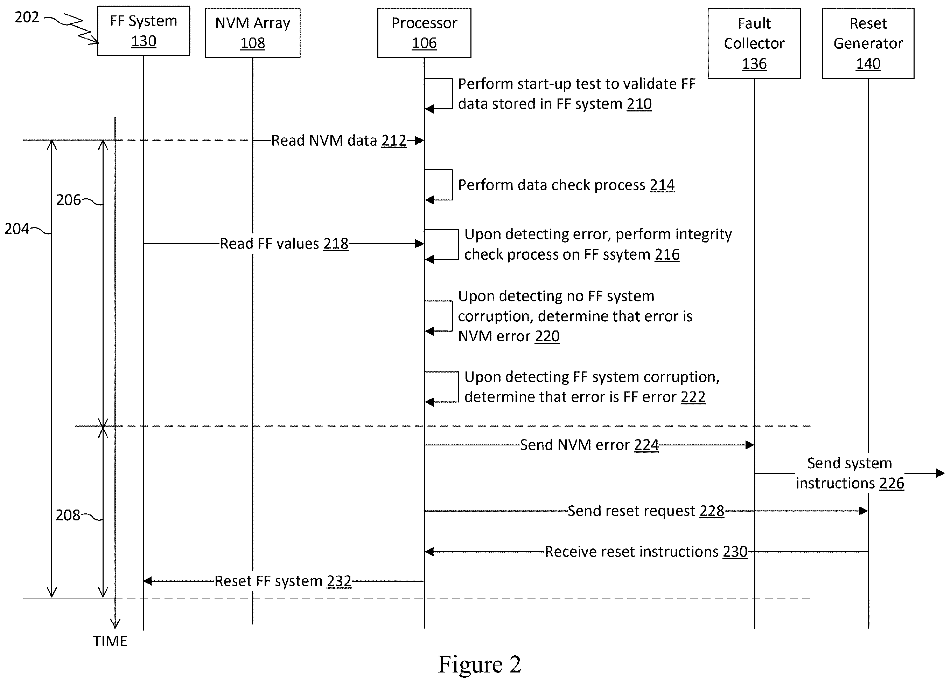

Figure 2 is a sequence diagram of a method for protecting internal flip-flops of a non-volatile memory (e.g., NVM 102 of Figures 1A and 1B), according to some embodiments. The sequence diagram shows relationships between different components and events during error detection and response. The sequence diagram is described in conjunction with Figure 1A. In some embodiments, a memory corruption event 202 may affect FF values 134 stored in the FF system 130. Memory corruption event 202 may be caused by radiation effects, voltage fluctuations, or other environmental factors.

In step 210, the processor 106 of the NVM 102 performs a start-up test to validate FF values 134 stored in FF system 130. This initial validation ensures the integrity of the FF system 130. In some embodiments, the start-up test comprises performing an integrity check process on the FF system 130 as described below with reference to step 216. In step 212, the processor 106 reads a portion of NVM data 110. Subsequently, an error detection and reaction processes are performed within a fault handling time interval (FHTI) 204 in steps 214-232. In particular, the error detection process is performed within a fault detection time interval (FDTI) 206 in steps 214-222, and the reaction process is performed within a fault reaction time interval (FRTI) 208 in steps 224-232. In some embodiments, FHTI 204 comprises a sum of FDTI 206 and FRTI 208. These time intervals represent timing requirements for the error detection and system response and may be set based on NVM applications. For example, FHTI 204, FDTI 206 and FRTI 208 may be set according to requirements for automotive applications.

In step 214, processor 106 performs a data check process on the read portion of NVM data 110. In some embodiments, processor 106 executes ECC algorithm 116 stored in NVM array 108. Subsequently, processor 106 determines whether an error is detected in the read portion of NVM data 110. In some embodiments, the detected error may be a single-bit flip error, a double-bit flip error, or a triple-bit flip error.

Upon detecting the error, in step 216, processor 106 performs an integrity check process on the FF system 130. In some embodiments, the integrity check process includes reading FF values 134 stored in FF system 130 in step 218 and determining whether any of FF values 134 are corrupted. The integrity check process may determine that one or more of FF values 134 are corrupted.

In some embodiments, performing the integrity check process comprises executing, by processor 106, integrity check algorithm 118 stored in NVM array 108. Upon detecting no corruption of the FF system 130, in step 220, the processor 106 determines that the error detected in step 216 is an NVM error. Upon detecting the corruption of the FF system, in step 222, the processor 106 determines that the error detected in step 216 is an FF error.

Following step 220, in step 224, processor 106 sends the NVM error (e.g., error 126) to the fault collector 136. In step 226, fault collector 136 generates system instructions 138 based on the NVM error and sends system instructions 138 to external controllers that are configured to provide a response based on the NVM error.

Following step 222, in step 228, processor 106 generates reset request 128 and sends reset request 128 to reset generator 140. In step 230, reset generator 140 generates reset instructions 142 based on reset request 128 and sends the reset instructions 142 to processor 106. In step 232, processor 106 resets FF system 130 based on reset instructions 142. In some embodiments, processor 106 may overwrite one or more corrupted FF values of FF values 134 determined at step 216 with one or more FF values of FF values 112 that correspond to the one or more corrupted FF values of FF values 134. In other embodiments, processor 106 may overwrite all FF values 134 with respective FF values 112.

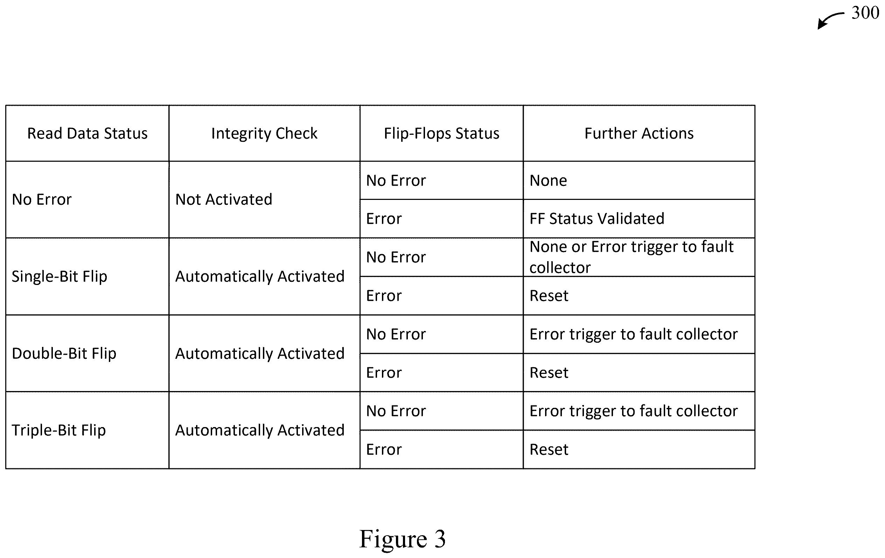

Figure 3 illustrates a table 300 showing a framework for error handling and system responses across different scenarios, in accordance with some embodiments. In an embodiment, when no error is detected in read NVM data (e.g., portion of NVM data 110 of Figures 1A and 1B), the integrity check process in not automatically activated. However, if the error detection process is part of the initialization process for an NVM (e.g., NVM 102 of Figures 1A and 1B), the integrity check process may be conducted on FF system (e.g., FF system 130 of Figures 1A and 1B) to validate FF values (e.g., FF values 134 of Figures 1A and 1B) stored in the FF system (e.g., FF system 130 of Figures 1A and 1B). In an embodiment, when the FF system (e.g., FF system 130 of Figures 1A and 1B) is not corrupted, no further action is needed. In an embodiment, when the FF system (e.g., FF system 130 of Figures 1A and 1B) is corrupted, the FF values (e.g., FF values 134 of Figures 1A and 1B) stored in the FF system (e.g., FF system 130 of Figures 1A and 1B) is validated.

Additionally of alternatively, when a single-bit flip error is detected in read NVM data (e.g., portion of NVM data 110 of Figures 1A and 1B), the integrity check is automatically activated. In such embodiment, if the FF system (e.g., FF system 130 of Figures 1A and 1B) is not corrupted, a memory system (e.g., memory system 100A or 100B of Figures 1A and 1B) either takes no action or sends an NVM error (e.g., error 126 of Figures 1A and 1B) to a fault collector (e.g., fault collector 136 of Figures 1A and 1B). In some embodiments, the choice between taking no action or sending the NVM error (e.g., error 126 of Figures 1A and 1B) to the fault collector (e.g., fault collector 136 of Figures 1A and 1B) may be made based on determining whether an error response rule is satisfied. In an embodiment, the error response rule may be determined as satisfied when a configurable response parameter matches a reference value. If the FF system (e.g., FF system 130 of Figures 1A and 1B) is corrupted, the memory system (e.g., memory system 100A or 100B of Figures 1A and 1B) initiates a reset operation for the FF system (e.g., FF system 130 of Figures 1A and 1B).

Additionally of alternatively, when a double-bit flip error is detected in read NVM data (e.g., portion of NVM data 110 of Figures 1A and 1B), the integrity check is automatically activated. In such embodiment, if the FF system (e.g., FF system 130 of Figures 1A and 1B) is not corrupted, a memory system (e.g., memory system 100A or 100B of Figures 1A and 1B) sends an NVM error (e.g., error 126 of Figures 1A and 1B) to a fault collector (e.g., fault collector 136 of Figures 1A and 1B). However, if the FF system (e.g., FF system 130 of Figures 1A and 1B) is corrupted, the memory system (e.g., memory system 100A or 100B of Figures 1A and 1B) initiates a reset operation for the FF system (e.g., FF system 130 of Figures 1A and 1B). In some embodiments, the memory system (e.g., memory system 100A or 100B of Figures 1A and 1B) further determines whether the NVM error comprises more than three bit flips.

Additionally of alternatively, when a triple-bit flip error is detected in read NVM data (e.g., portion of NVM data 110 of Figures 1A and 1B), the integrity check is automatically activated. In such embodiment, if the FF system (e.g., FF system 130 of Figures 1A and 1B) is not corrupted, a memory system (e.g., memory system 100A or 100B of Figures 1A and 1B) sends an NVM error (e.g., error 126 of Figures 1A and 1B) to a fault collector (e.g., fault collector 136 of Figures 1A and 1B). However, if the FF system (e.g., FF system 130 of Figures 1A and 1B) is corrupted, the memory system (e.g., memory system 100A or 100B of Figures 1A and 1B) initiates a reset operation for the FF system (e.g., FF system 130 of Figures 1A and 1B). In some embodiments, the memory system (e.g., memory system 100A or 100B of Figures 1A and 1B) further determines whether the NVM error comprises more than three bit flips.

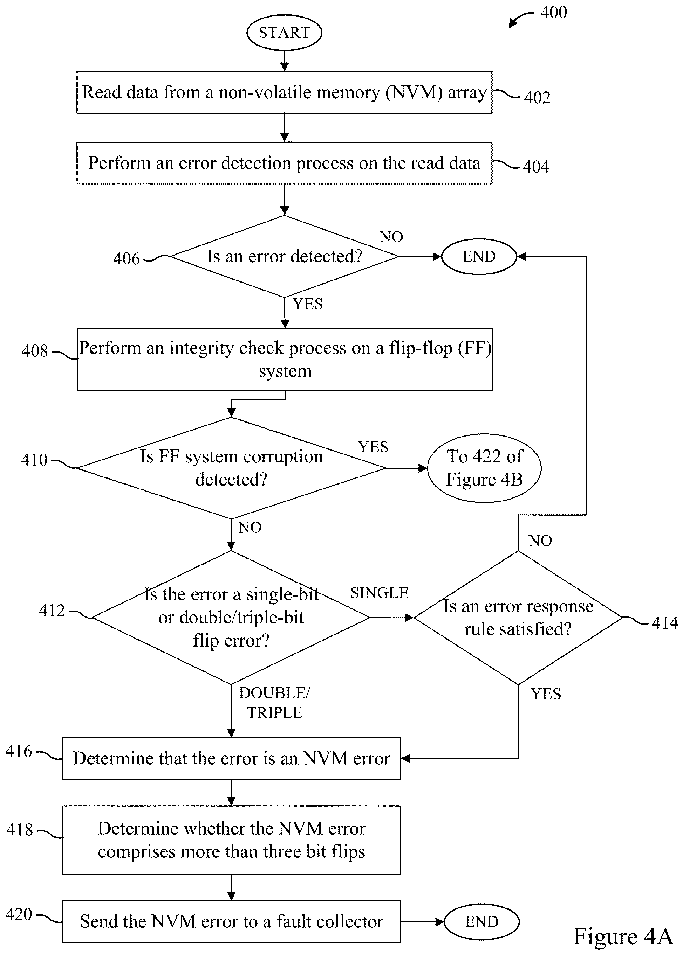

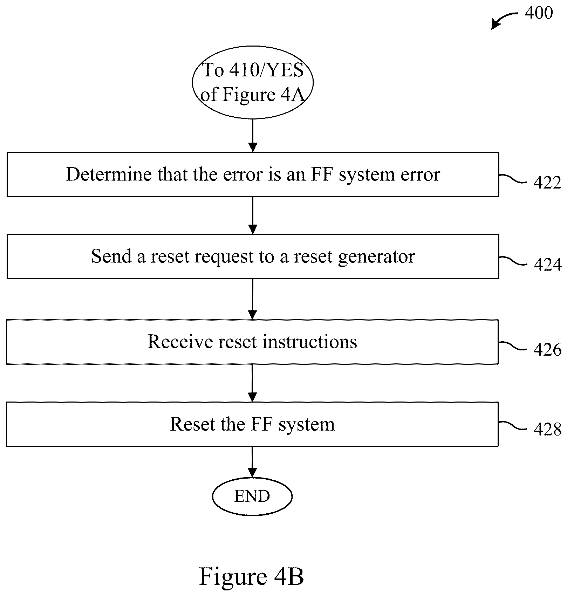

Figures 4A and 4B illustrate a flowchart of a method 400 for protecting internal flip-flops of a non-volatile memory, in accordance with some embodiments. Method 400 is described in conjunction with Figure 1A. Method 400 may be implemented, at least in part, in the form of executable code (e.g., instructions 114, ECC algorithm 116, integrity check algorithm 118, and error reporting algorithm 120 of Figure 1A) stored on non-transitory, tangible, computer-readable medium (e.g., NVM array 108 of Figure 1A) that when executed by one or more processors (e.g., processor 106 of Figure 1A) may cause the one or more processors to perform one or more of steps 402-428. Although shown in a particular sequence, it should be appreciated that the steps of method 400 may be performed in any suitable sequence. Figures 4A and 4B illustrate example operations that may be performed by processor 106 in connection with the approach of Figure 2. In various embodiments, the activation of the integrity check and the resulting system response follow the rules summarized in Table 300 of Figure 3.

Method 400 starts with step 402, when a processor (e.g., processor 106 of Figure 1A) of an NVM (e.g., NVM 102 of Figure 1A) reads data (e.g., portion of NVM data 110 of Figure 1A) from an NVM array (e.g., NVM array 108 of Figure 1A) of the NVM (e.g., NVM 102 of Figure 1A). In step 404, the processor (e.g., processor 106 of Figure 1A) performs an error detection process on the read data (e.g., portion of NVM data 110 of Figure 1A). In some embodiments, the processor (e.g., processor 106 of Figure 1A) executes an ECC algorithm (e.g., ECC algorithm 116 of Figure 1A) stored in the NVM array (e.g., NVM array 108 of Figure 1A) while performing the error detection process.

In step 406, the processor (e.g., processor 106 of Figure 1A) determines whether an error is detected in the read data (e.g., portion of NVM data 110 of Figure 1A). In response to determining at step 406 that no error is detected, method 400 proceeds to end. In response to determining at step 406 that error is detected, method 400 proceeds to step 408. In some embodiments, the detected error (e.g., error 126 of Figure 1A) may be a single-bit flip error, a double-bit flip error, or a triple-bit flip error.

In step 408, the processor (e.g., processor 106 of Figure 1A) performs the integrity check process on an FF system (e.g., FF system 130 of Figure 1A). In some embodiments, the processor (e.g., processor 106 of Figure 1A) executes an integrity check algorithm (e.g., integrity check algorithm 118 of Figure 1A) stored in the NVM array (e.g., NVM array 108 of Figure 1A) while performing the integrity check process. In some embodiments, the integrity check process includes reading FF values (e.g., FF values 134 of Figure 1A) stored in the FF system (e.g., FF system 130 of Figure 1A) and determining whether any of the FF values (e.g., FF values 134 of Figure 1A) are corrupted. In an embodiment, the integrity check process may determine that one or more of the FF values (e.g., FF values 134 of Figure 1A) are corrupted.

In step 410, the processor (e.g., processor 106 of Figure 1A) determines whether FF system corruption is detected. In response to determining at step 410 that FF system corruption is not detected, method 400 proceeds to step 412. In step 412, the processor (e.g., processor 106 of Figure 1A) determines whether the error detected at step 406 is a single-bit flip error or a double/triple-bit flip error. In response to determining at step 412 that the error detected at step 406 is the single-bit flip error, method 400 proceeds to step 414. In step 414, the processor (e.g., processor 106 of Figure 1A) determines whether an error response rule is satisfied. In some embodiment, the processor (e.g., processor 106 of Figure 1A) may determine the error response rule as satisfied when a configurable response parameter matches a reference value. In response to determining at step 414 that the error response rule is not satisfied, method 400 proceeds to end.

In response to determining at step 412 that the error detected at step 406 is the double/triple-bit flip error or determining at step 414 that the error response rule is satisfied, method 400 proceeds to step 416. In step 416, the processor (e.g., processor 106 of Figure 1A) determines that the error (e.g., error 126 of Figure 1A) detected at step 406 is an NVM error. In step 418, the processor (e.g., processor 106 of Figure 1A) may determine whether the NVM error comprises more than three bit flips. In an embodiment, the processor (e.g., processor 106 of Figure 1A) executes an ECC algorithm (e.g., ECC algorithm 116 of Figure 1A) stored in the NVM array (e.g., NVM array 108 of Figure 1A) while determining whether the NVM error comprises more than three bit flips. In some embodiments, step 418 may be omitted.

In step 420, the processor (e.g., processor 106 of Figure 1A) sends the NVM error (e.g., error 126 of Figure 1A) to a fault collector (e.g., fault collector 136 of Figure 1A). In some embodiments, the fault generator (e.g., fault collector 136 of Figure 1A) generates system instructions (e.g., system instructions 138 of Figure 1A) based on the NVM error (e.g., error 126 of Figure 1A) and sends system instructions (e.g., system instructions 138 of Figure 1A) to an external controller that is configured to provide a response based on the NVM error. In some embodiments when the NVM error is a double/triple-bit flip error, the system instructions (e.g., system instructions 138 of Figure 1A) may comprise instructions to repair the NVM data (e.g., NVM data 110 of Figures 1A and 1B). In other embodiments when the NVM error comprises more than three bit flips, the system instructions (e.g., system instructions 138 of Figure 1A) may comprise instructions to send the NVM (e.g., NVM 102 of Figure 1A) for a failure analysis. After step 420, method 400 proceeds to end.

In response to determining at step 410 that FF system corruption is detected, method 400 proceeds to step 422. In step 422, the processor (e.g., processor 106 of Figure 1A) determines that the error detected at step 406 is an FF system error. In step 424, the processor (e.g., processor 106 of Figure 1A) sends a reset request (e.g., reset request 128 of Figure 1A) to a reset generator (e.g., reset generator 140 of Figure 1A). In step 426, the processor (e.g., processor 106 of Figure 1A) receives reset instructions (e.g., reset instructions 142 of Figure 1A) from the reset generator (e.g., reset generator 140 of Figure 1A). In step 428, the processor (e.g., processor 106 of Figure 1A) resets the FF system (e.g., FF system 130 of Figure 1A). In some embodiments, the processor (e.g., processor 106 of Figure 1A) overwrites one or more corrupted FF values among the FF values (e.g., FF values 134 of Figure 1A) stored in the FF system (e.g., FF system 130 of Figure 1A) with one or more respective uncorrupted FF values among FF values (e.g., FF values 112 of Figure 1A) stored in the NVM array (e.g., NVM array 108 of Figure 1A). In other embodiments, the processor (e.g., processor 106 of Figure 1A) overwrites all of the FF values (e.g., FF values 134 of Figure 1A) stored in the FF system (e.g., FF system 130 of Figure 1A) with respective FF values (e.g., FF values 112 of Figure 1A) stored in the NVM array (e.g., NVM array 108 of Figure 1A). After step 428, method 400 proceeds to end.

Method 400 allows for proper handling of both NVM errors and FF system errors while providing appropriate error correction and system reset mechanisms when needed. Method 400 provides a comprehensive framework for maintaining data integrity and system stability through various fault scenarios.

While this disclosure has been described with reference to illustrative embodiments, this description is not intended to be construed in a limiting sense. Various modifications and combinations of the illustrative embodiments, as well as other embodiments of the disclosure, will be apparent to persons skilled in the art upon reference to the description. It is therefore intended that the appended claims encompass any such modifications or embodiments.

## Claims

1. A non-volatile memory, NVM, (102) comprising:
- a NVM array (108) configured to store an NVM data (110) and first flip-flop, FF, values (112);
- an FF system (130) configured to store second FF values (134); and
- a processor (106) operably coupled to the NVM array (108) and the FF system (130), wherein the processor (106) is configured to:
- read a portion of the NVM data (110) from the NVM (102);
- perform an error detection process on read portion of the NVM data (110); and
- in response to detecting an error in the read portion of the NVM data (110):
- perform an integrity check process on the FF system (130), wherein performing the integrity check process comprises determining whether any of second FF values (134) of the FF system (130) are corrupted; and
- in response to detecting FF system (130) corruption:
- determine that the error is an FF system error;
- send a reset request (128) to a reset generator (140);
- receive reset instructions (142) from the reset generator (140); and
- reset the FF system (130).

2. The non-volatile memory of Claim 1, wherein the processor (106) is further configured to:
- in response to detecting no FF system corruption:
- determine that the error is an NVM error (126); and
- send the NVM error (126) to a fault collector (136).

3. The non-volatile memory of Claim 1 or Claim 2, wherein the error is a single-bit flip error, a double-bit flip error, or a triple-bit flip error.

4. The non-volatile memory of any of the previous claims, wherein resetting the FF system (130) comprises:
- reading one or more first FF values (112) from the NVM array (108) that correspond to one or more corrupted second FF values (134) of the FF system (130); and
- overwriting the one or more corrupted second FF values (134) with corresponding one or more first FF values (112).

5. The non-volatile memory of any of the previous claims, wherein the second FF values (134) comprise mapping tables that redirect accesses from defective wordlines or bitlines to spare wordlines or bitlines, and defect location addresses detected during post-manufacturing tests.

6. The non-volatile memory of any of the previous claims, wherein:
- the NVM array (108) is further configured to store an error correction code, ECC, algorithm (116); and
- performing the error detection process on the read portion of the NVM data (110) comprises executing the ECC algorithm (116).

7. The non-volatile memory of any of the previous claims, wherein:
- the NVM array (108) is further configured to store an integrity check algorithm (118); and
- performing the integrity check process on the FF system (130) comprises executing the integrity check algorithm (118).

8. A system (100A; 100B) comprising:
- a fault collector (136);
- a reset generator (140); and
- a non-volatile memory, NVM, (102) according to any of the previous claims.

9. The system of Claim 8, wherein the fault collector (136) is configured to generate system instructions (138) based on the NVM error (126).

10. The system of Claim 8 or Claim 9, wherein the reset generator (140) is configured to generate the reset instructions (142) based on the reset request (128).

11. A method comprising:
- reading (402) data from a non-volatile memory (NVM) array;
- performing (404) an error detection process on read data; and
- in response to detecting an error in the read data (406):
- performing (408) an integrity check process on a flip-flop (FF) system, wherein performing the integrity check process comprises determining whether any of FF values of the FF system are corrupted; and
- in response to detecting FF system corruption (410):
- determining (422) that the error is an FF system error;
- sending (424) a reset request to a reset generator;
- receiving (426) reset instructions from the reset generator; and
- resetting (428) the FF system.

12. The method of Claim 11, further comprising:
- in response to detecting no FF system corruption (410):
- determining (416) that the error is an NVM error; and
- sending (420) the NVM error to a fault collector.

13. The method of Claim 12, further comprising generating system instructions based on the NVM error.

14. The method of any of Claims 11 to 13, wherein resetting the FF system comprises:
- reading (218) FF values from the NVM array that correspond to corrupted FF values of the FF system; and
- overwriting the corrupted FF values with corresponding read FF values.

15. The method of Claim 14, wherein the FF values comprise mapping tables that redirect accesses from defective wordlines or bitlines to spare wordlines or bitlines, and defect location addresses detected during post-manufacturing tests.
